# EUROPEAN PATENT APPLICATION

(11) **EP 4 737 918 A1**
(43) Date of publication of application: **06.05.2026**
(21) Application number: 24306821.0
(22) Date of filing: 29.10.2024
(51) Int. Cl.: G01R 31/26, H03K 17/18

(54) **A POWER DEVICE SYSTEM**

(71) Applicant: NXP USA, Inc., Austin TX 78735 (US)
(72) Inventor: RYABCHENKOV,, Sergey Sergeevich, 31023 Toulouse (FR); KANDAH,, Ibrahim Shihadeh, 5656 AG Eindhoven (NL); BOURLOT,, Xavier Antoine Theophile, 31023 Toulouse (FR)
(74) Representative: Schmütz, Christian Klaus Johannes

(57) **Abstract**

A power device system (100) comprising: a power device (101) and a controller (102), the power device (101) comprising: a power switch (103); and a control terminal driver (104), and wherein the power device (101) is configured to operate in both a ramp-up and ramp-down diagnostic mode in which the control terminal driver (104) is respectively configured to: apply a test current at the first node of the conduction channel (105) of the power switch (103); apply a first driver voltage that is less than or greater than the threshold voltage at control terminal (106) of the power switch (103); increase or decrease, respectively, the first driver voltage until a voltage drop or voltage increase, respectively is detected; and measure the first driver voltage at which the voltage drop is detected as a ramp-up threshold voltage or ramp-down threshold voltage, respectively, wherein the controller (102) is configured to determine a state of health of the power switch (101) based on the ramp-up threshold voltage and the ramp-down threshold voltage.

## Description

### Field

The present disclosure relates to a power device system, power apparatus and a method of determining the state of health of a power switch.

### Summary

According to a first aspect of the present disclosure, there is provided a power device system comprising: a power device and a controller, the power device comprising: a power switch comprising a conduction channel and a control terminal wherein current is configured to flow from a first node of the conduction channel to a second node of the conduction channel upon a voltage at the control terminal reaching a threshold voltage; and a control terminal driver configured to control a voltage applied to the control terminal of the power switch, and wherein the power device is configured to operate in a power switch diagnostic mode comprising both a ramp-up diagnostic mode and a ramp-down diagnostic mode, wherein in the ramp-up diagnostic mode, the control terminal driver is configured to: apply a test current at the first node of the conduction channel; apply a first driver voltage that is less than the threshold voltage at the control terminal; increase the first driver voltage until a voltage drop across the conduction channel of the power switch is detected; and measure the first driver voltage at which the voltage drop is detected as a ramp-up threshold voltage; and in the ramp-down diagnostic mode, the control terminal driver is configured to: apply the test current to the first node of the conduction channel; apply a second driver voltage that is greater than the threshold voltage at the control terminal; decrease the second driver voltage until a voltage increase across the conduction channel of the power switch is detected; and measure the second driver voltage at which the voltage increase is detected as a ramp-down threshold voltage; and wherein the controller is configured to determine a state of health of the power switch based on the ramp-up threshold voltage and the ramp-down threshold voltage.

In one or more embodiments, the controller may be configured to determine the state of health of the power switch by comparing the ramp-up threshold voltage and the ramp-down threshold voltage to one or more historical threshold voltages.

In one or more embodiments, the historical threshold value may be stored in a memory of the controller.

In one or more embodiments, in the ramp-up diagnostic mode, the control terminal driver may be configured to apply a first preconditioning voltage at the control terminal for a first preconditioning time wherein the first preconditioning voltage and the first preconditioning time are the same each time the ramp-up diagnostic mode is utilised.

In one or more embodiments, in the ramp-down diagnostic mode, the control terminal driver may be configured to apply a second preconditioning voltage at the control terminal for a second preconditioning time wherein the second preconditioning voltage and the second preconditioning time are the same each time the ramp-down diagnostic mode is utilised.

In one or more embodiments, the first preconditioning time may be the same as the second preconditioning time.

In one or more embodiments, the power device may be configured to operate in the power switch diagnostic mode a plurality of times in succession such that a plurality of ramp-up threshold voltages and ramp-down threshold voltages are recorded wherein, each time the power device operates in the power switch diagnostic mode, a different test current is used and wherein the controller is configured to determine a transconductance of the power switch based on the plurality of ramp-up threshold voltages and the ramp-down threshold voltages and wherein the state of health of the power switch is based on the transconductance of the power switch.

In one or more embodiments, the power device system may further comprise a comparator configured to detect the voltage drop or the voltage increase across the conduction channel of the power switch.

In one or more embodiments, the power device system may further comprise an analog-to-digital converter configured to measure the voltage applied to the control terminal of the power switch when a voltage drop or voltage increase is detected across the conduction channel of the power switch.

In one or more embodiments, the power device may comprise a temperature sensor configured to determine a temperature at the power switch and wherein the controller is configured to determine the state of health of the power switch further based on the determined temperature.

In one or more embodiments, the control terminal driver may be an intelligent gate driver.

According to a second aspect of the present disclosure, there is provided a power apparatus comprising the power device system of any preceding claim.

According to a third aspect of the present disclosure, there is provided a method of determining a state of health of a power switch comprising a conduction channel and a control terminal, wherein current is configured to flow from a first node of the conduction channel to a second node of the conduction channel upon a voltage at the control terminal reaching a threshold voltage, the method comprising: applying a test current to the first node of the conduction channel; applying, by way of a control terminal driver, a first driver voltage less than the threshold voltage at the control terminal; increasing, by way of the control terminal driver, the first driver voltage until a voltage drop across the conduction channel of the power switch is detected; measuring the voltage at which the voltage drop was detected as a ramp-up threshold voltage; applying the test current to the first node of the conduction channel; applying, by way of the control terminal driver, a second driver voltage greater than the threshold voltage at the control terminal; decreasing, by way of the control terminal driver, the second driver voltage until a voltage increase across the conduction channel of the power switch is detected; measuring the voltage at which the voltage increase the voltage increase is detected as a ramp-down threshold voltage; and determining a state of health of the power switch based on the ramp-up threshold voltage and the ramp-down threshold voltage.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

### Brief Description of the Drawings

One or more embodiments will now be described by way of example only with reference to the accompanying drawings in which:
Figure 1 shows a schematic representation of an example embodiment of a power device system;
Figure 2 shows further example embodiment of a power device system;
Figure 3 shows the effect of using a preconditioning voltage for a preconditioning time on settling time on gate-source voltage; and
Figure 4 shows how test current correlates with the gate-source voltage of a power switch using a preconditioning voltage for different preconditioning times;
Figure 5 shows an example power apparatus comprising a power device of the present disclosure; and
Figure 6 shows an example method of determining a state of health of a power switch.

### Detailed Description

Incipient Fault Detection or early warning of a power device's degradation of performance due to aging or other system stresses continue to be a topic of interest in systems where reliability and safety are a concern. The ability to interrogate a power switch and monitor its health over the lifetime of the product is a powerful feature allowing system designers to anticipate failures and alert users to the need for service prior to a catastrophic failure event. Intelligent Gate Drive products offer the possibility of a unique method of interrogation of the power switch terminal behaviour and the ability to communicate that behaviour to a Microcontroller Unit (MCU) or other device where trends can be analysed and decisions made as to a possibility of an imminent failure.

The present disclosure is directed towards a power device system that comprises a power switch which is able to operate in a diagnostic mode that allows for a determination of the state of health of the power switch.

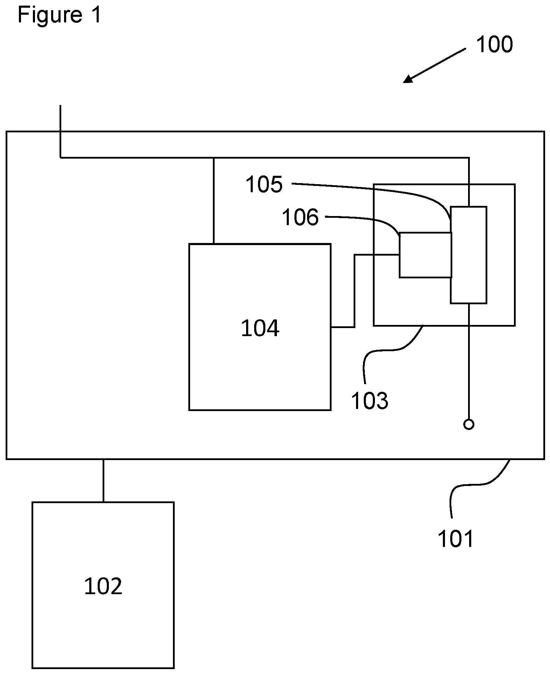

Figure 1 shows a schematic representation of a power device system 100. The power device system 100 comprises a power device 101 and a controller 102. The power device comprises both a power switch 103 and a control terminal driver 104.

A power switch 103 according to the present disclosure may be an IGBT (insulated gate bipolar transistor) or a power MOSFET (Metal-Oxide-Semiconductor Field-Effect Transistor) or other another suitable power switch device 103 that may be used in high-power devices. It will be appreciated that, while different types of power switches 103 use different nomenclature for their various terminals, and some power switches 103 may have additional terminals, a common feature of a power switch is the presence of a conduction channel 105 which can act as a switch or variable resistor controlled by a voltage applied at a control terminal 106. The conduction channel 105 is configured to conduct current from a first node of the conduction channel 105 to a second node of the conduction channel 105 upon a voltage reaching a threshold voltage at the control terminal 106 reaching a threshold voltage. In some examples the control terminal 106 may comprise a base or a gate. In some examples, the nodes of the conduction channel 105 may comprise a collector and an emitter or a source and a drain. The voltage at the control terminal 106 may be more accurately be referred to as the voltage between the gate and the second node of the conduction channel 105. This may be referred to as the gate-source voltage, however, as already mentioned, gate and source may not be the terms used to refer to the terminals of the power switch 103, depending on the exact nature of the power switch 103 in question.

The control terminal driver 104 may be, for example, a gate driver circuit such as an intelligent gate driver. Control terminal driver 104 may have several functions unrelated to self-diagnostics. For example, the control terminal driver 104 may be configured to control whether a power switch 103 operates in a regulation mode, a pull mode or a controlled shutdown mode. Such additional modes will not be described further herein, however, suffice it to say that the control terminal driver 104 may be configured to provide for the operation of the power switch 103 in one of a plurality of modes, wherein a self-diagnostic mode may be one of those modes, by controlling a voltage provided at the control terminal 106 of the power switch 103. Thus, the use of a control terminal driver 104 which is configured to provide for operation in one of a plurality of modes, including the self-diagnostic mode, may be particularly beneficial, as it allows the power device system 100 to make use of pre-existing components for the implementation of a self-diagnostic mode and associated functionality.

The power device 101 may be configured to operate in a power switch diagnostic mode which itself comprises both a ramp-up diagnostic mode and a ramp-down diagnostic mode. Each of these diagnostic modes are configured to obtain a respective ramp threshold voltage. The ramp threshold voltages may be used together in order to determine a state of health of the power switch. The ramp-up diagnostic mode and the ramp-down diagnostic mode may be performed in any order.

The ramp-up diagnostic mode may be a mode in which the control terminal driver 104 is configured to apply a test current at a first node of the conduction channel 105. The test current may be a constant current which is provided at the first node of the conduction channel 105 in order to detect when the power switch is opened and current flows. The test current may be provided by a current source within the control terminal driver 104. The test current may be provided by the control terminal driver 104 from a terminal which is otherwise used for other functions when the power switch is operated in other modes. For example, the current may be provided from a desaturation terminal of the control terminal driver 104 where the desaturation terminal is otherwise used for overcurrent protection of the power device 101.

The ramp-up diagnostic mode may further comprise applying a first driver voltage that is less than the threshold voltage of the power switch 103 at the control terminal 106 of the power switch 103. In particular, the first driver voltage may be initially set to a value which is lower than an expected threshold voltage of the power switch 103. The expected threshold voltage of the power switch 103 may be based on historical threshold voltages, which may be based on a data-sheet standard value indicative of the expected initial threshold voltage of the power switch 103 or it may be a previously measured threshold voltage captured during a ramp-up diagnostic mode at a point earlier in time.

The ramp-up diagnostic mode may further comprise increasing the first driver voltage until a voltage drop across the conduction channel 105 of the power switch 103 is detected. The voltage drop across the conduction channel 105 of the power switch 103 may be detected in any suitable way. For example, the voltage drop across the conduction channel 105 may be detected by the control terminal driver 104 and, in one or more embodiments, may be detected by desaturation circuitry which is otherwise configured to detect voltage drops across the conduction channel 105 when operating in other modes. The voltage drop across the conduction channel 105 may be detected, for example, by a comparator configured to compare a voltage across the conduction channel to a threshold voltage. In other embodiments, the voltage drop across the conduction channel 105 may be detected by an external detector or sensor which is external to the power device system 100 but is configured to interface with the power device system 100. For example, such an external detector or sensor may be coupled to the power switch 103 or another component impacted by a voltage drop across the conduction channel 105. Such an external detector or sensor may be further configured to provide signalling to the power device system 100 indicative of the voltage drop across the conduction channel 105.

The ramp-up diagnostic mode may further comprise measuring the first driver voltage at which the voltage drop is detected as a ramp-up threshold voltage. A signal indicative of the measured first driver voltage may be provided to the controller 102 or another component for use and/or recordal. The signal may be provided to the controller by the control terminal driver 104. The voltage measurement may be performed by any suitable device, such an analog-to-digital converter (ADC) configured to measure a voltage applied to the control terminal of the power switch when a voltage drop across the conduction channel 105 is detected.

In one or more embodiments, the voltage drop may need to be greater than a predetermined voltage drop threshold in order to trigger the measurement of the first driver voltage. The predetermined voltage drop threshold may be, for example, a voltage drop greater than, for example 3-15 Volts. In one or more embodiments, the voltage drop threshold may be 9 Volts. In one or more embodiments, when the power device is off, i.e. when the voltage at the control terminal is less than the threshold voltage, the voltage across the conduction channel will generally be the VCC voltage of the control terminal driver 104. This VCC voltage may be, for example, in the range of 15 - 20 Volts.

The ramp-down diagnostic mode may be a mode in which the control terminal driver 104 is configured to apply a test current at the first node of the conduction channel 105. The test current may be a constant current which is provided at the first node of the conduction channel 105 in order to detect when the power switch 103 is closed and current stops flowing. The test current may be provided by a current source. The test current may be provided by the control terminal driver 104 from a terminal which is otherwise used for other functions when the power switch 103 is operated in other modes. For example, the current may be provided from a desaturation terminal of the control terminal driver 104 where the desaturation terminal is otherwise used for overcurrent protection of the power device.

The ramp-down diagnostic mode may further comprise applying a second driver voltage that is greater than the threshold voltage of the power switch 103 at the control terminal 106 of the power switch. In particular, the second driver voltage may be initially set to a value which is greater than an expected threshold voltage of the power switch 103. The expected threshold voltage of the power switch 103 may be based on historical threshold voltages, which may be based on a data-sheet standard value indicative of the expected initial threshold voltage of the power switch 103 or it may be a previously measured threshold voltage captured during a ramp-up diagnostic mode at a point earlier in time.

The ramp-down diagnostic mode may further comprise decreasing the second driver voltage until a voltage increase across the conduction channel 105 of the power switch 103 is detected. The voltage increase across the conduction channel 105 of the power switch 103 may be detected in any suitable way. For example, the voltage increase across the conduction channel 105 may be detected by the control terminal driver 104 and, in particular, may be detected by desaturation circuitry which is otherwise configured to detect voltage increases or drops across the conduction channel 105 when operating in other modes. The voltage increase across the conduction channel 105 may be detected, for example, by a comparator configured to compare a voltage across the conduction channel 105 to a threshold voltage. In other embodiments, the voltage increase across the conduction channel 105 may be detected by an external detector or sensor which is external to the power device system 100 but is configured to interface with the power device system 100. For example, such an external detector or sensor may be coupled to the power switch or another component impacted by a voltage increase across the conduction channel 105. Such an external detector or sensor may be further configured to provide signalling to the power device system 100 indicative of the voltage increase across the conduction channel 105.

The ramp-down diagnostic mode may further comprise measuring the second driver voltage at which the voltage increase is detected as a ramp-down threshold voltage. A signal indicative of the measured second driver voltage may be provided to the controller 102 or another component for use and/or recordal. The voltage measurement may be performed by any suitable device, such an analog-to-digital converter (ADC) configured to measure a voltage applied to the control terminal 106 of the power switch 103 when a voltage increase across the conduction channel 105 is detected.

In one or more embodiments, the voltage increase may need to be greater than a predetermined voltage increase threshold in order to trigger the measurement of the second driver voltage. The predetermined voltage increase drop threshold may be, for example, a voltage increase greater for example 3-15 Volts. In one or more embodiments, the voltage drop threshold may be 9 Volts..

The controller 102 may be configured to determine a state of health of the power switch 103 based on the ramp-up threshold voltage and the ramp-down threshold voltage. In particular, the controller 102 may determine a true threshold voltage based on the ramp-up threshold voltage and the ramp-down threshold voltage. The state of health may be determined based on the true threshold voltage. By determining the state of health based on the true threshold voltage, instead of based on one of the ramp-up threshold voltage or the ramp-down threshold voltage, the state of health of the power switch 103 can be determined independent of the impact of trapped charges in the power switch 103. The trapped charges can lead to significant impacts on the determined state of health, if not accounted for properly. The power device system of the present disclosure provides for the ability to overcome disadvantages inherent in relying on voltage threshold values which are impacted by trapped charges. In one or more embodiments, the ramp-up threshold voltage and the ramp-down threshold voltage may be averaged in order to obtain the true threshold voltage, or an approximation of the true threshold voltage. Other approaches specific to the power switch in question may also be used.

The conversion from up and down threshold voltages to the state of health may be specific to the power switch 103 in question. That is, there may be a plurality of ways to obtain the true threshold voltage wherein the method used is dependent on the power switch. Thus, determination of the true threshold voltage may involve determining a true threshold voltage based on the ramp-up threshold voltage, the ramp-down threshold voltage and the type of power switch 103. However, once a true threshold voltage or state of health has been determined, the controller 102 may be configured to make a lifetime evaluation by looking at the degradation over time. The degradation over time and degradation rate may be calculated simply based on one or more historical threshold values, which may include historical measurements or data sheet values. The historical threshold values may be stored in the controller 102 or in a different memory associated with the power device system 100.

The controller 102 may be any suitable controller 102. For example, the controller 102 may be a microcontroller unit (MCU) which is independent of the other components described herein. In one or more alternative embodiments, the controller 102 may be part of the control terminal driver 104.

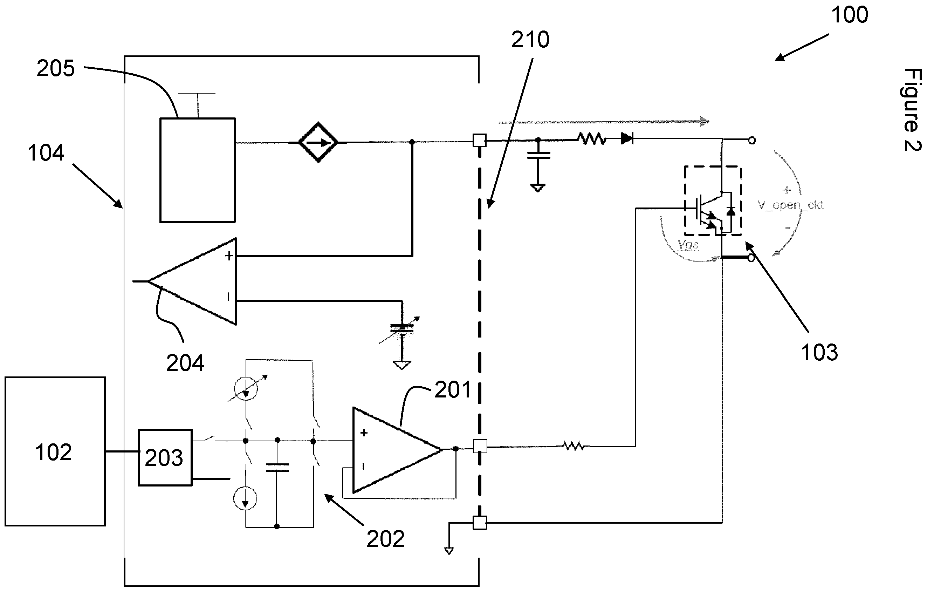

Figure 2 shows an example embodiment of the power device system of claim 1 showing further details of how the circuit may be implemented. Features which are the same as those represented in figure 1 are provided with like-reference numerals in order to make comparisons easier. In this embodiment, the components on the left side of 210, apart from the controller 102, all form part of the control terminal driver 104, which may be an intelligent gate driver. In one or more embodiments, the control driver 104 may comprise an operational amplifier 201 configured to provide the voltage for application to the control terminal of the power switch 103. That is, the operational amplifier 201 may provide the first voltage and the second voltage, depending on the mode of operation of the power device system 100. The control terminal driver 104 may further comprise a voltage-setting arrangement 202 comprising a plurality of components configured to provide an input signal to the operational amplifier 201 configured to set the output voltage of the operational amplifier 201. The output voltage may be any voltage in a continuous range of voltages, as opposed to a discrete step implementation. The continuous range of voltages may be a suitable continuous range in order to provide for operation of the power switch. In one or more embodiments the input to the ADC may be as represented in figure 2 wherein the input to the ADC is the positive input of the operational amplifier. In one or more other embodiments, the input to the ADC may be connected directly to the output of the op amp. The control terminal driver 104 may further comprise an ADC 203 configured to measure the first voltage or the second voltage upon the detection of a voltage drop or a voltage increase, respectively, across the conduction channel of the power switch 103. The voltage drop or voltage increase across the conduction channel of the power switch 103 may be detected by a comparator 204 configured to compare a voltage at a first terminal thereof to a reference voltage at a reference terminal thereof. The comparator 204 may provide its output signal to the ADC 203 as a trigger to cause the ADC 203 to take a voltage measurement. It will be appreciated that the above provides one way of implementing the provision and measurement of the first and second voltages, however, a range of other circuit configurations may be used to achieve the functionality described herein. The control terminal driver 104 may further comprise a current source 205 configured to provide the test current to the first node of the power switch 103.

The power device system 100 may further comprise a temperature sensor (not shown) configured to measure a temperature at the power switch 103. The temperature sensor may directly measure the temperature of the power switch 103 or it may measure a direct temperature at location in the vicinity of the power switch 103 such that the temperature measurement provides an indirect measurement of the temperature of the power switch 103. Since the temperature of the power switch 103 may impact the threshold voltage, the temperature measurement may be used in determining the state of health of the power switch 103. For example, the temperature measurement may be used in order to calibrate or scale the state of health or measured threshold voltages in order to allow for comparable results to be obtained, regardless of the temperature of the power switch 103. In other embodiments, the temperature measurement may be used to ensure that the power switch 103 diagnostic mode is only entered when the power switch is at, or within an acceptable range of, a measurement temperature. By taking this approach, it may be possible to ensure consistent and comparable threshold voltage, and thereby state of health, measurements. In yet other embodiments, the power device system 100 may comprise a heater configured to adjust the temperature of the power switch 103. The heating functionality may be provided, for example, by an inverter, but may be provided by one or more other components. In such an embodiment, the power device system 100 may be configured to, prior to performing the ramp-up or ramp-down diagnostic modes, adjust the temperature of the power switch 103 to a measurement temperature in order to provide for consistent temperatures between state of health measurements.

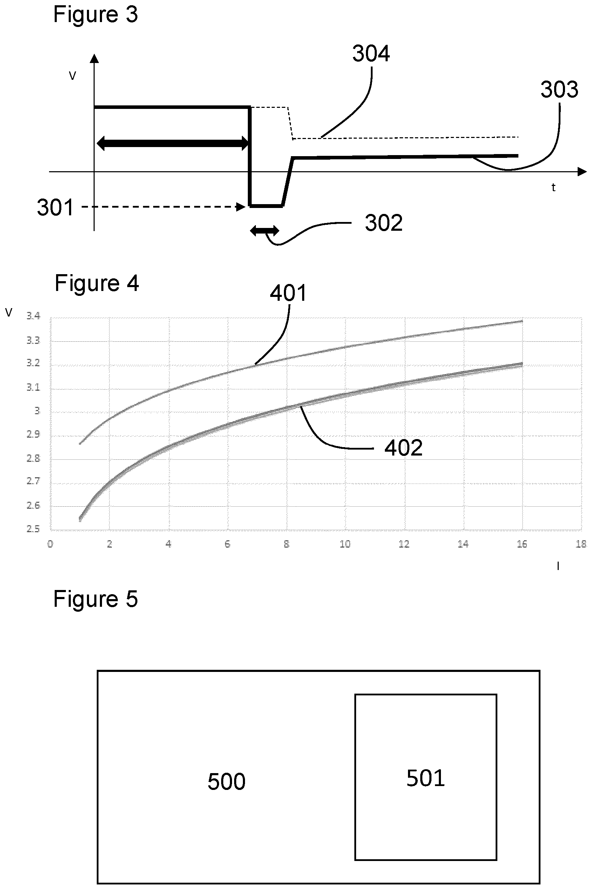

Figure 3 shows an example timing-voltage diagram which demonstrates one embodiment for how the first voltage can be applied to the control terminal of the power switch. In this example, the control terminal driver may be configured to apply a first preconditioning voltage 301 at the control terminal for a first preconditioning time 302 prior to performing the other steps of the ramp-up diagnostic mode. The preconditioning voltage 301 and preconditioning time 302 may provide for a consistent state in which the ramp-up threshold voltage 303 can be determined. In one or more embodiments, the first preconditioning voltage 301 may be a negative voltage. For example, the first preconditioning voltage 301 may range from -10V to the expected threshold voltage, which may be 1-3V. The preconditioning times 302 may range from tens of µs to several seconds. Figure 3 also demonstrates the threshold voltage 304 if a preconditioning voltage applied for a preconditioning time is not used.

It will be appreciated that an equivalent approach can be taken prior to initiating the ramp-down diagnostic mode. That is, the control terminal driver may be configured to apply a second preconditioning voltage at the control terminal for a second preconditioning time prior to performing the other steps of the ramp-down diagnostic mode. The preconditioning voltage and preconditioning time may provide a consistent state in which the ramp-down threshold voltage can be determined. In one or more embodiments, the second preconditioning voltage may be a positive voltage. In one or more embodiments, the second preconditioning voltage may range from the expected threshold voltage, which may be 1-3V to 22V.

Figure 4 shows how variations in test current impact the threshold voltage of the power switch when the power device system is operating in a ramp-up diagnostic mode. The first line 401 shows the impact of the variations in test current when no preconditioning voltage is applied for a preconditioning time. The second line 402 shows the impact of the variations in test current when a preconditioning voltage is applied for a preconditioning time. While not shown, a similar correlation can be seen between the test current and the threshold voltage when operating in the ramp-down diagnostic mode both when using a preconditioning voltage for a preconditioning time and when not using a preconditioning voltage for a preconditioning time.

In order to obtain a plot such as that shown in figure 4, the power device system 100 may be configured to operate in the power switch diagnostic mode a plurality of times in succession such that a plurality of ramp-up threshold voltages and ramp-down threshold voltages are recorded. Each time the power device system 100 operates in the power switch diagnostic mode, a different test current may be used. It will be appreciated that, in some embodiments, the power device system 100 may be configured to operate in the ramp-up diagnostic mode a plurality of times in succession followed by operation in the ramp-down diagnostic mode a plurality of times in succession. In other examples, the ramp-up and ramp-down diagnostic modes may be alternated. The controller 102 may be configured to determine a transconductance of the power switch 103 based on the plurality of ramp-up threshold voltages and the ramp-down threshold voltages. The state of health of the power switch 103 may be based on the transconductance of the power switch 103. In one or more embodiments, by changing the test current injected into the power switch and measuring the threshold voltage for two different current injection levels, one is able to calculate the transconductance. For example, the transconductance may be calculated as (I2 - I1)/(Vₜₕ₂ - Vₜₕ₁).

Figure 5 shows an example power apparatus 500 comprising the power device system 501 described above. The power apparatus 500 may be any apparatus that comprises a power converter. For example, the power apparatus 500 may be an automotive vehicle comprising an automotive traction inverter which, in turn, comprises the power device system 501 of the present disclosure.

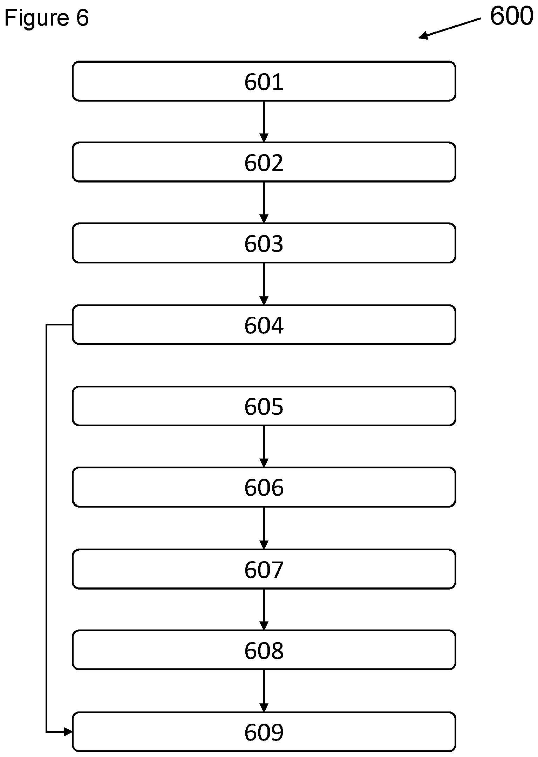

Figure 6 shows a method of determining a state of health of the power switch according to the present disclosure. The method comprises applying 601 a test current to the first node of the condition channel. The method further comprises applying 602, by way of the control terminal driver, a first driver voltage less than the threshold voltage at the control terminal. The method further comprises increasing 603, by way of the control terminal driver, the first driver voltage until a voltage drop across the power switch is detected. The method further comprises 604 measuring the voltage at which the voltage drop was detected as a ramp-up threshold voltage. The method also comprises applying 605 the test current to the first node of the conduction channel. The method also comprises applying 606, by way of the control terminal driver, a second driver voltage greater than the threshold voltage at the control terminal. The method further comprises decreasing 607, by way of the control terminal driver, the second driver voltage until a voltage increase across the conduction channel of the power switch is detected. The method also comprises measuring 608 the voltage at which the voltage increase the voltage increase is detected as a ramp-down threshold voltage. Finally, the method comprises determining 609 a state of health of the power switch based on the ramp-up threshold voltage and the ramp-down threshold voltage. It will be appreciated that in this method, both the ramp-up (601 - 604) and the ramp-down (605 - 608) diagnostic modes are described. It does not matter whether the ramp-up diagnostic mode or the ramp-down diagnostic mode is performed first or second.

The instructions and/or flowchart steps in the above figures can be executed in any order, unless a specific order is explicitly stated. Also, those skilled in the art will recognize that while one example set of instructions/method has been discussed, the material in this specification can be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor can refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture can refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification can be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

## Claims

1. A power device system comprising:
a power device and a controller, the power device comprising:
a power switch comprising a conduction channel and a control terminal wherein current is configured to flow from a first node of the conduction channel to a second node of the conduction channel upon a voltage at the control terminal reaching a threshold voltage; and
a control terminal driver configured to control a voltage applied to the control terminal of the power switch, and
wherein the power device is configured to operate in a power switch diagnostic mode comprising both a ramp-up diagnostic mode and a ramp-down diagnostic mode, wherein in the ramp-up diagnostic mode, the control terminal driver is configured to:
apply a test current at the first node of the conduction channel;
apply a first driver voltage that is less than the threshold voltage at the control terminal;
increase the first driver voltage until a voltage drop across the conduction channel of the power switch is detected; and
measure the first driver voltage at which the voltage drop is detected as a ramp-up threshold voltage; and
in the ramp-down diagnostic mode, the control terminal driver is configured to:
apply the test current to the first node of the conduction channel;
apply a second driver voltage that is greater than the threshold voltage at the control terminal;
decrease the second driver voltage until a voltage increase across the conduction channel of the power switch is detected; and
measure the second driver voltage at which the voltage increase is detected as a ramp-down threshold voltage; and
wherein the controller is configured to determine a state of health of the power switch based on the ramp-up threshold voltage and the ramp-down threshold voltage.

2. The power device system of claim 1 wherein the controller is configured to determine the state of health of the power switch by comparing the ramp-up threshold voltage and the ramp-down threshold voltage to one or more historical threshold voltages.

3. The power device system of claim 2 wherein the historical threshold value is stored in a memory of the controller.

4. The power device system of any preceding claim wherein, in the ramp-up diagnostic mode, the control terminal driver is configured to apply a first preconditioning voltage at the control terminal for a first preconditioning time wherein the first preconditioning voltage and the first preconditioning time are the same each time the ramp-up diagnostic mode is utilised.

5. The power device system of any preceding claim wherein, in the ramp-down diagnostic mode, the control terminal driver is configured to apply a second preconditioning voltage at the control terminal for a second preconditioning time wherein the second preconditioning voltage and the second preconditioning time are the same each time the ramp-down diagnostic mode is utilised.

6. The power device system of claim 4 and claim 5 wherein the first preconditioning time is the same as the second preconditioning time.

7. The power device system of any preceding claim wherein the power device is configured to operate in the power switch diagnostic mode a plurality of times in succession such that a plurality of ramp-up threshold voltages and ramp-down threshold voltages are recorded wherein, each time the power device operates in the power switch diagnostic mode, a different test current is used and wherein the controller is configured to determine a transconductance of the power switch based on the plurality of ramp-up threshold voltages and the ramp-down threshold voltages and wherein the state of health of the power switch is based on the transconductance of the power switch.

8. The power device system of any preceding claim further comprising a comparator configured to detect the voltage drop or the voltage increase across the conduction channel of the power switch.

9. The power device system of any preceding claim further comprising an analog-to-digital converter configured to measure the voltage applied to the control terminal of the power switch when a voltage drop or voltage increase is detected across the conduction channel of the power switch.

10. The power device system of any preceding claim wherein the power device comprises a temperature sensor configured to determine a temperature at the power switch and wherein the controller is configured to determine the state of health of the power switch further based on the determined temperature.

11. The power device system of any preceding claim wherein the control terminal driver is an intelligent gate driver.

12. A power apparatus comprising the power device system of any preceding claim.

13. A method of determining a state of health of a power switch comprising a conduction channel and a control terminal, wherein current is configured to flow from a first node of the conduction channel to a second node of the conduction channel upon a voltage at the control terminal reaching a threshold voltage, the method comprising:
applying a test current to the first node of the conduction channel;
applying, by way of a control terminal driver, a first driver voltage less than the threshold voltage at the control terminal;
increasing, by way of the control terminal driver, the first driver voltage until a voltage drop across the conduction channel of the power switch is detected;
measuring the voltage at which the voltage drop was detected as a ramp-up threshold voltage;
applying the test current to the first node of the conduction channel;
applying, by way of the control terminal driver, a second driver voltage greater than the threshold voltage at the control terminal;
decreasing, by way of the control terminal driver, the second driver voltage until a voltage increase across the conduction channel of the power switch is detected;
measuring the voltage at which the voltage increase the voltage increase is detected as a ramp-down threshold voltage; and
determining a state of health of the power switch based on the ramp-up threshold voltage and the ramp-down threshold voltage.
